# EUROPÄISCHE PATENTSCHRIFT

(11) **EP 0 845 053 B1**
(45) Veröffentlichungstag und Bekanntmachung des Hinweises auf die Patenterteilung: **10.10.2001**
(21) Anmeldenummer: 96924786.5
(22) Anmeldetag: 27.07.1996
(51) Int. Cl.: C23C 16/36

(54) **VERBUNDKÖRPER UND VERFAHREN ZU DESSEN HERSTELLUNG**
COMPOSITE BODY AND PROCESS FOR ITS PRODUCTION
CORPS COMPOSITE ET SON PROCEDE DE PRODUCTION

(30) Priorität: 19.08.1995 DE 19530517; 19.08.1995 DE 19530518
(43) Veröffentlichungstag der Anmeldung: 03.06.1998
(73) Patentinhaber: Widia GmbH, 45145 Essen (DE)
(72) Erfinder: TABERSKY, Ralf, D-46240 Bottrop (DE); WESTPHAL, Hartmut, D-36466 Dermbach (DE); VAN DEN BERG, Hendrikus, NL-5925 BT Venlo-Blerick (NL); KÖNIG, Udo, D-45149 Essen (DE); SOTTKE, Volkmar, D-45468 Mülheim (DE)
(74) Vertreter: Vomberg, Friedhelm, Dipl.-Phys.
(86) Internationale Anmeldenummer: DE9601425
(87) Internationale Veröffentlichungsnummer: WO9707260

(56) Entgegenhaltungen:
- FR-A- 2 171 334
- US-A- 4 169 913
- US-A- 4 269 899
- PATENT ABSTRACTS OF JAPAN vol. 004, no. 171 (M-044), 26.November 1980 & JP,A,55 120936 (HITACHI METALS LTD), 17.September 1980,
- HTM HARTEREI- TECHNISCHE MITTEILUNGEN, Bd. 49, Nr. 4, Juli 1994, DE, Seiten 272-276, XP000459599 K. BARTSCH ET AL: "HERSTELLUNG, CHARAKTERISIERUNG UND EIGENSCHAFTEN ZIRKONIUM ENTHALTENDER CVD-TIC UND TICN-SCHICHTEN"
- PATENT ABSTRACTS OF JAPAN vol. 011, no. 251 (C-440), 14.August 1987 & JP,A,62 056564 (MITSUBISHI METAL CORP), 12.März 1987,

## Beschreibung

Die Erfindung betrifft ein Verfahren zur Herstellung von Multikomponenten-, insbesondere quaternären, Hartstoffschichten mit mindestens zwei Metallen aus der Gruppe Ti, Zr, Hf, V, Nb, Ta, Cr, Mo und W.

Die Erfindung betrifft ferner einen Verbundkörper, bestehend aus einem Hartmetall-, Cermet-, Stahl- oder Keramik-Substratkörper und mindestens einer Metallcarbonitrid-Hartstoffschicht.

Mit Hartstoff beschichtete Substratkörper sind nach dem Stand der Technik bekannt. Durch die jeweils aufgetragene Hartstoffbeschichtung, ggf. als Mehrlagenbeschichtung, kann eine verschleißbeständige Oberflächenschicht mit zähen, mechanisch hochbelasteten Grundkörpern kombiniert werden. Grundsätzlich werden zum Auftragen der Hartstoffschichten zwei verschiedene Verfahren, die sogenannte Chemical-Vapour-Deposition (CVD) oder die Physical-Vapour-Deposition (PVD) angewendet. Insbesondere sind bei Schneidwerkzeugen zur spanenden Bearbeitung von Werkstücken solche Beschichtungen zur Verlängerung der Gebrauchsdauer der Schneidwerkzeuge bekannt. Übliche Schutzschichten bestehen beispielsweise aus TiC, TiN und/oder Aluminiumoxid. Es sind auch bereits Mehrlagenbeschichtungen mit der Schichtfolge TiN, Ti(C,N), Ti(C,N), TiN auf einem Substratkörper mit beliebigen C:N-Mischungsverhältnissen vorgeschlagen worden.

Zur Herstellung von Verschleißschutzschichten für spanende Werkzeuge aus Schnellarbeitsstählen werden hauptsächlich PVD-Verfahren angewendet, während man für Werkzeuge aus Hartmetallen vorzugsweise CVD-Verfahren benutzt. Beide Verfahren haben Vor- und Nachteile. Während man PVD-Beschichtungen bereits ab ca. 400°C herstellen kann, benötigt man bei den CVD-Verfahren weitaus höhere Temperaturen, die in der Regel um ca. 1000°C liegen. Hieraus folgt, daß temperaturempfindliche, zu beschichtende Substrate mittels des PVD-Verfahrens beschichtet werden, allerdings ist bei dieser Beschichtungsvariante eine gleichmäßige Rundumbeschichtung von kompliziert geformten Körpern schwierig und aufwendig.

In "Surface and Coatings Technology", 33, (1987) Seite 91 bis 103, werden Eigenschaften von ternären Nitriden und Carbonitriden der Metalle Titan, Zirkon, Hafnium, Vanadium, Niob, Chrom und Aluminium, hergestellt durch Kathodenzerstäubung (Sputtern) untersucht. Bei Beschichtungen aus (Zr,Ti)(C,N),(Zr,Ti)(C,N),(Nb,-Ti)(C,N) sowie (Hf,Ti)C und (Hf,Ti)C konnten große Mikrohärten erreicht werden.

Darüber hinaus ist aus der DE-A1-25 05 009 ein Verfahren zum Beschichten von anorganischen Substraten mit Carbiden, Nitriden und/oder Carbonitriden des Eisens, Bors, Siliciums oder der Übergangsmetalle der Nebengruppen IVa bis VIa des Periodischen Systemes durch direkte thermische Reaktion von den Metallen oder Derivaten davon mit Kohlenstoff und Stickstoff liefernden Substanzen, ggf. in Gegenwart weiterer Zusätze bekannt, bei dem als Kohlenstoff- und Stickstofflieferanten u.a. Verbindungen verwendet werden sollen, die Cyan-Gruppen mit einer Dreifachbindung zwischen dem Kohlenstoff und dem Stickstoff enthalten. Als eine dieser Verbindungen wird Acetonitril genannt. Die Beschichtung soll mittels CVD erfolgen. Die beschriebenen Verbindungen sind ausschließlich Monometall-Carbide, -nitride oder Carbonitride, wobei sich beim Versuch einer Nacharbeitung der in dieser Schrift gegebenen Lehre ergeben hat, daß das Zr(C,N) nach diesem Verfahren nicht herstellbar ist. In allen Fällen liegen die Abscheideraten pro Zeiteinheit sehr niedrig.

In jüngerer Zeit gewinnt auch das durch ein Glimmentladungsplasma aktivierte CVD-Verfahren an Bedeutung (PCVD). Mit diesem Verfahren können haftfeste Hartstoffschichten ähnlich wie beim PVD-Verfahren bereits ab etwa 450°C auf Werkzeugen abgeschieden werden. Ein solches Verfahren wird beispielsweise in der DE 38 41 731 zur Abscheidung von Carbiden, Nitriden oder Carbonitriden von Titan oder Zirkonium beschrieben. Die einzelnen abgeschiedenen Schichten bestehen aus Titan- oder Zirkonium-Nitrid, -Carbid oder -Carbonitrid.

Hiervon ausgehend ist es Aufgabe der vorliegenden Erfindung, ein Verfahren anzugeben, mit dem Multikomponenten-Hartstoffschichten mit mindestens zwei Metallen der IVa- bis VIa-Gruppen als Carbonitridschichten herstellbar sind. Angestrebt wird ein hohes Schichtwachstum, um die Beschichtungszeit entsprechend zu minimieren. Die hergestellten Schichten sollen die Eigenschaften der einfachen binären Verbindungen, wie z.B. der Carbide und Nitride des Titans oder Zirkoniums, beträchtlich übertreffen.

Ferner ist es Aufgabe der vorliegenden Erfindung, Verbundkörper der eingangs genannten Art zu schaffen, deren Beschichtung ein möglichst glatte Schichtoberfläche aufweist, insbesondere zur Herstellung von vorgeformten gesinterten Werkzeugen, deren Außenkonturen durch die Beschichtung möglich unverändert bleiben sollen.

Die das Verfahren betreffende Aufgabenstellung wird zum einen durch die Merkmalskombination des Anspruches 1 gelöst.

Erfindungsgemäß werden die Multikomponenten-Hartstoffschichten mittels CVD aufgetragen, wobei die Gasphase bei einer Reaktionstemperatur zwischen 700°C und 1100°C und vorzugsweise bei Drücken zwischen 5 kPa und 100 kPa neben H₂ und/oder Ar (als Transportgas) sowie Metallchloriden auch Kohlenstoff- und Stickstoffdonatoren enthält, die eine C-N-Molekülgruppe aufweisen. Diese C-N-Molekülgruppe ist vorzugsweise eine Cyanid-Gruppe mit einer Dreifachbindung zwischen dem Kohlenstoff und dem Stickstoff, deren Abstand bei Raumtemperatur zwischen 0,114 und 0,118 nm liegt. Als solcher Kohlenstoff- und Stickstoffdonator bietet sich vorzugsweise Acetonitril an. Die Gasmischung kann jedoch auch CN-Molekülgruppen mit einer einfachen C-N-Bindung enthalten. In die betreffende Gasmischung, aus der sich der Carbonitridhartstoff abscheidet, können beliebige Verbindungen eingegeben werden, die eine Cyanid-Gruppe enthalten. Verbindungen dieser Art sind im Prinzip nach dem Stand der Technik bekannt und werden beispielsweise in der DE-A1-25 05 009 beschrieben. Es können auch andere gasförmige Medien in das Reaktionsgefäß eingeschleust werden, die in der Lage sind, betreffende Cyangruppen-CN bei Reaktionstemperatur zu bilden. Unter Einhaltung dieser Verfahrensvorschrift ist es entgegen dem nach dem Stand der Technik bestehenden Vorurteil, bei gleichzeitigem Einleiten von zwei oder mehreren Metallchloriden nur dasjenige mit den günstigeren thermochemischen Daten bei der Schichtbildung zur Reaktionsabscheidung zu bringen, auch möglich, beide Metalle in die Hartstoffschicht unter Bildung entsprechender einphasiger Carbonitride einzubringen. Überraschenderweise ergaben sich bei gleichzeitiger Anwesenheit von beispielsweise ZrCl₄ und TiCl₄ Abscheideraten, die um ein Vielfaches höher lagen als die Abscheideraten, die sich bei Anwesenheit nur eines Metallchlorids in der Gasphase bei der CVD ergaben. Das erfindungsgemäße Verfahren wird vorzugsweise zur Abscheidung einer Hartstoffschicht (Ti,Zr)(C,N) benutzt. Es kann jedoch ebenso erfolgreich auf das quaternäre System (Ti,Hf)(C,N) angewendet werden. In entsprechender Weise muß anstelle des Zirkoniumtetrachlorid Hafniumtetrachlorid in die Gasphase eingeschleust werden. Ebenso ist es möglich, andere Chloride der Elemente Vanadium, Niob, Tantal und Chrom zu verwenden. Besonders geeignete Stoffe, die bei der Reaktionstemperatur Cyanradikale -CN freisetzen können, sind organische Verbindungen wie Cyanwasserstoff CHN, Cyanamid H₂N-CN, Cyanogen NC-CN, Cyanoazethylen HC-C-CN und das bereits erwähnte Acetonitril CH₃-CN. Die Bindungslängen der -CN-Gruppen liegen zwischen 0,114 und 0,118 nm.

Es konnten auch quaternäre Hartstoffschichten der Art (Ti,Zr)(C,N) mit Stoffen hergestellt werden, deren Moleküle einfache C-N-Bindungen aufweisen. Hierzu gehören Verbindungen wie Methylamin H₃C-NH₂ und Ethylendiamin NH₂-CH₂-CH₂-NH₂. In solchen Gasgemischen wird jedoch das vorhandene Zirkoniumtetrachlorid nicht vollständig umgesetzt.

Die Aufgabe wird ferner durch das im Anspruch 4 beschriebene PCVD-Verfahren gelöst. Versuche haben ergeben, daß es nicht ausreichend ist, das im Prinzip aus der DE 38 41 731 C1 bekannte plasmaaktivierte CVD-Verfahren dergestalt anzuwenden, daß ein Gasgemisch aus Titan- und Zirkoniumchlorid, Methan, Stickstoff, Wasserstoff und Argon in den Reaktionsraum eingeleitet und die erforderliche Reaktionstemperatur eingestellt wurde. Obwohl Titan- und Zirkoniumtetrachlorid in gleicher Menge vorhanden waren, bildete sich nur eine Ti(C,N)-Schicht, in der nur eine geringe Menge an Zirkonium (<1 %) aufzufinden war.

Überraschenderweise konnten jedoch quaternäre Hartstoffschichten (Ti,Zr)(C,N) abgeschieden werden, wenn das obengenannte Gasgemisch neben den beiden Metallchloriden Wasserstoff und Argon zusätzlich gasförmige Stoffe enthält, die Cyanid-Fragmente oder Cyanid-Radikale CN mit Dreifachbindungen zwischen dem Kohlenstoff und dem Stickstoff bei der Reaktionstemperatur bilden können. Mit der vorliegenden Erfindung wird ein allgemein für CVD-Techniken bestehendes Vorurteil überwunden, daß beim gleichzeitigen Einleiten von zwei oder mehr Metallchloriden nur dasjenige mit den günstigeren thermochemischen Daten bei der Schichtbildung zur Reaktion gelangt. Das erfindungsgemäße Verfahren konnte insbesondere zur Abscheidung von quaternären Systemen der Art Ti-Zr-C-N und Ti-Hf-C-N angewendet werden oder auf solche Multikomponenten-Carbonitrid-Hartstoffschichten, die beliebige Kombinationen der Elemente der IVa- oder Va-Gruppe des Periodensystems aufwiesen.

Weiterbildungen des erfindungsgemäßen Verfahrens sind in den Ansprüchen 5 bis 8 beschrieben.

So werden vorzugsweise die ionisierten und die nicht ionisierten C-N-Donatoren als Molekül- oder Ionenfragmente durch Ionisierung und bzw. oder thermische Dissoziation von Gasen mit Cyanid-Gruppen mittels einer Plasmaaktivierung bei Temperaturen zwischen 400°C und 700°C erzeugt. Bevorzugt wurde dem Reaktionsgasgemisch Acetonitril als Kohlenstoff-Stickstoff-Donator beigegeben. Das Gasgemisch kann auch Kohlenstoff-Stickstoff-Donatoren mit CN-Gruppen enthalten, bei denen zwischen dem Kohlenstoff und dem Stickstoff eine Einfachbindung besteht. Hierdurch ergeben sich beispielsweise folgende Stoffe, die bei der Reaktionstemperatur geeignete Cyanid-Gruppen oder -Radikale freisetzen können: Cyanwasserstoff CHN, Cyanamid H₂N-CN, Cyanogen NC-CN, Cyanoacethylen HC-C-CN und Acetonitril CH₃-CN. Die Bindungslängen der CN-Radikale sollen jeweils zwischen 0,114 nm und 0,118 nm liegen. CN-Einfachbindungen in den Radikalen erhält man, wenn dem Gasgemisch Verbindungen, wie Methylamin H₃C-NH₂ und Ethylendiamin NH₂-CH₂-CH₂-NH₂ beigegeben werden. Bei alleiniger Zugabe dieser Stoffe wurde das Zirkoniumchlorid jedoch nicht vollständig umgesetzt, so daß das Gasgemisch bevorzugt zumindest teilweise CN-Fragmente mit Dreifachbindungen enthalten sollte.

Die auf den Verbundkörper bezogene Aufgabe wird durch die Merkmalskombination nach Anspruch 9 gelöst.

Der neue Verbundkörper besteht aus einem Hartmetall-, Cermet-, Stahl- oder Keramik-Substratkörper und mindestens einer sauerstofffreien Metallcarbonitrid Hartstoffschicht, wobei das Metall aus zwei oder mehreren Elementen der IVa- bis VIa-Gruppe besteht. Die sauerstoffreie Carbonitrid-Hartstoffschicht soll mittels CVD-Verfahren oder eines plasmaaktivierten CVD-Verfahrens unter Bildung einer einphasigen Schicht mit einheitlicher Struktur und Gitterkonstanten abgeschieden worden sein. Die Metallcarbonitridschicht als quaternäre Schicht soll die Zusammensetzung (TiₓZr₁₋ₓ)(C_{y}N_{1-y}) mit 0,4<x<0,95 und 0,2<y<0,9 mit einer kubisch flächenzentrierten Gitterstruktur aufweisen, deren Gitterkonstante im Bereich zwischen 0,430 und 0,455 liegt oder daß die abgeschiedene Schicht die Zusammensetzung (TiₓHf₁₋ₓ)(C_{y}N_{1-y}) mit 0,4<x<0,95 und 0,2<y<0,9 mit einer kubisch flächenzentrierten Gitterstruktur aufweist, deren Gitterkonstante im Bereich zwischen 0,430 und 0,450 liegt.

Beispielsweise Hartstoffschichten aus dem Stoffsystem Ti-Zr-C-N haben Eigenschaftswerte, die die Eigenschaften der einfachen binären Verbindungen TiC, ZrC, TiN und ZrN beträchtlich übertreffen. Wie bereits in der eingangs zitierten Literaturstelle "Surface and Coatings Technology", 33 (1987), Seiten 91 bis 103, ausgeführt, weisen bereits die ternären Mischcarbide (Ti,Zr)C höhere Härtewerte als die binären Carbide TiC und ZrC auf (vgl. auch DE-Zeitschrift Metall, 35. Jahrgang, Heft 10, Oktober 1981, Seiten 999 1004, H. Holleck, "Ternäre Carbidsysteme der hochschmelzenden Übergangsmetalle"). Mischcarbide der Art (Ti,Zr)C bestehen aus einer einheitlichen Phase und haben die gleiche kubische Kristallstruktur wie ihre binären Komponenten. Das Titan und das Zirkonium verteilt sich in statistischer Weise auf die Plätze des Untergitters der Metallatome. Ähnlich verhält es sich mit dem Mischnitriden der Art (Ti,Zr)N, wobei besonders harte Schichten bei einem Verhältnis der Ti- und Zr-Atome von etwa 70 : 30 Atom-% erhalten werden. Noch höhere Härten wurden beobachtet, wenn das Metalloid Stickstoff gleichzeitig noch teilweise durch Kohlenstoff substituiert wurde, wobei ebenfalls einphasige Hartstoffe der Art (Ti,Zr)(C,N) gefunden wurden, deren Metallatome statistisch auf einem Untergitter und deren Metalloide C und N ebenfalls ungeordnet auf dem anderen Untergitter verteilt sind. Analoge Beobachtungen konnten in dem Stoffsystem Ti-Hf-C-N gemacht werden, in dem das Zirkonium durch das Element Hafnium ersetzt wurde. Auch hier wurden Härtewerte beobachtet, die jene der binären Carbide und Nitride beträchtlich übertreffen. Allerdings konnten diese genannten Hartstoffschichten nur durch das PVD-Verfahren als dünnlagige Schichten mit großen Aufwand hergestellt werden. Überraschenderweise hat sich ergeben, daß eine Abscheidung der bezeichneten Multikomponenten-Hartstoffschichten auch mittels des CVD-Verfahrens oder eines plasmaaktivierten CVD-Verfahrens (PCVD) möglich ist und daß die abgeschiedenen Multikomponenten-Schichten eine besonders niedrige Oberflächenrauhigkeit aufwiesen. Insbesondere sollen Verbundkörper angesprochen sein, die einen Hartmetall-Substratkörper aufweisen, auf dem eine oder mehrere Lagen mittels CVD oder PCVD aufgetragen werden sollen, wovon mindestens eine eine Multimetall-Carbonitrid-Hartstoffschicht ist. Im Unterschied zu Schnellarbeitsstählen können Hartmetalle ohne Schädigung der vorhandenen Gefügestruktur höheren Temperaturen ausgesetzt werden.

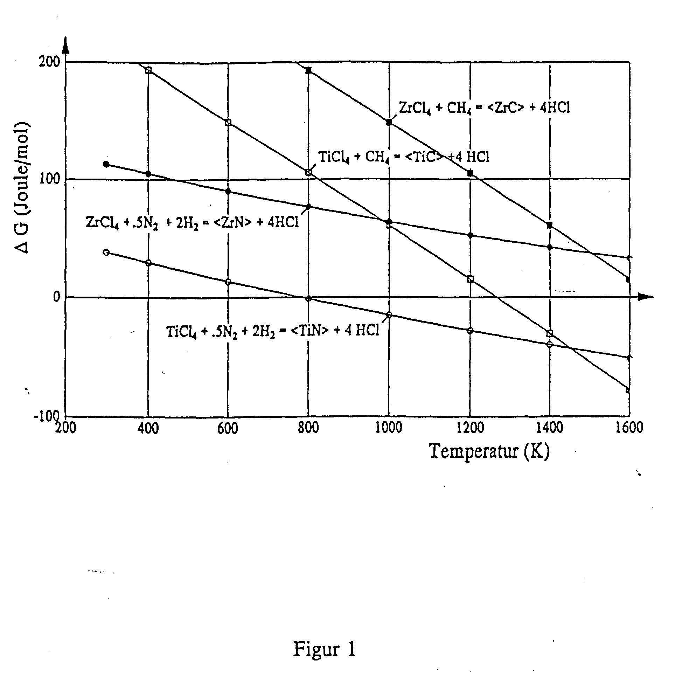

Das CVD-Verfahren ist grundsätzlich in der Literatur beschrieben worden. Um beispielsweise eine TiC-Schicht zu erzeugen, ist es nach dem Stand der Technik bekannt, ein Gasgemisch aus TiCl₄, CH₄ und H₂ (als Transportgas) bei etwa 1000°C über die zu beschichtenden Substrate zu leiten. Entsprechendes gilt für die Erzeugung von TiN-Schichten, bei denen anstelle des CH₄ N₂ verwendet wird. Leitet man gleichzeitig CH₄ und N₂ in die Gasphase ein, so entsteht Ti(C,N). Bei allen in der Literatur beschriebenen Carbid-, Nitrid- und Carbonitrid-Schichten handelt es sich jedoch um Verbindungen mit nur einem einzigen Metall. Dies ist dadurch zu erklären, daß die gleichzeitige Einleitung von TiCl₄, ZrCl₄, CH₄, N₂ und H₂ in die Gasphase des Reaktionsraumes nicht zu den gewünschten quaternären Verbindungen (Ti,Zr)(C,N) führt. Dies ist dadurch zu erklären, daß das chemische Gleichgewicht der Reaktion durch die Energiebilanz ΔG bestimmt wird, die man die freie Reaktionsenthalpie (oder Gibbs'sche Energie) nennt. Fig. 1 zeigt solche ΔG-Werte in Abhängigkeit von der Temperatur für CVD-Reaktionen, bei denen die Feststoffe TiC, TiN, ZrC und ZrN entstehen. Das chemische Gleichgewicht der jeweils dargestellten Reaktionen liegt um so mehr auf der rechten Seite, je niedriger die betreffenden ΔG-Werte sind. Bei Temperaturen von 1300 K sind diese Größen bei den Reaktionen für TiC und TiN viel niedriger als in den Fällen von ZrC und ZrN. Bei Einleitung des sowohl Titantetrachlorid als auch Zirkontetrachlorid enthaltenen Gasgemisches in den Reaktionsraum entstehen zwangsläufig TiC- und TiN-Schichten sowie durch Festkörperreaktion Ti(C,N), jedoch keine Carbide oder Nitride des Zirkon oder Titan-Zirkon-Carbonitride. Wie überraschend herausgefunden wurde, sind insbesondere quaternäre Carbonitrid-Schichten dennoch bei Einhaltung spezieller Versuchsbedingungen mittels CVD darstellbar.

Eine Beschreibung des PCVD-Verfahrens findet sich in der DE 38 41 731 C1. Bei einer Beschichtungstemperatur zwischen 400°C und 750°C wird das Substrat als Kathode geschaltet und hieran eine gepulste Gleichspannung angelegt. In den Pausen zwischen den stromstarken Pulsen mit Spannungen zwischen 200 und 900 V und einer Puls-Dauer zwischen 20 *µ*s und 20 ms wird eine Restspannung aufrechterhalten, die etwas größer als die Ionisierungspotentiale der Prozeßgase sein soll (vorzugsweise ca. 15 bis 20 eV). Im Reaktionsraum entsteht ein Glimmentladungsplasma, welches aus geladene Atomen, Molekülen und Molekülfragmenten besteht.

Die vorliegende Erfindung umfaßt auch Verbundkörper mit mehreren Lagen aus Carbiden, Nitriden und/oder Carbonitriden des Ti, Cr, Hf, insbesondere TiC, Ti(C,N), TiN, und/oder Al₂O₃ und mindestens einer Multimetallcarbonitridschicht. Vorzugsweise werden erfindungsgemäße Verbundkörper als Werkzeuge, insbesondere Schneidwerkzeuge zur spanenden Bearbeitung verwendet.

Ausführungsbeispiele der Erfindung, auch im Vergleich zu Abscheidungen, die nach dem Stand der Technik bekannt sind, werden im folgenden beschrieben.

Für die Versuche 1 bis 5 wurde eine CVD-Apparatur mit einem Reaktionsgefäß aus einer hitzebeständigen Stahllegierung verwendet, in dem etwa 600 Wendeschneidplatten (Abmessungen 12,4 x 12,4 x 4 mm) gleichzeitig beschichtet werden können. Die Temperatur kann auf Werte bis zu 1100°C und der Innendruck zwischen 500 und 100 kPa eingestellt werden. Durch eine Gasmischeinrichtung können Mischungen aus unterschiedlichen Gasen genau dosiert in das Reaktionsgefäß eingeleitet werden. Der Hauptbestandteil der zugeführten Gase ist Wasserstoff. Gasförmiges Titantetrachlorid wird durch Verdampfen von flüssigem Titantetrachlorid gewonnen. Gasförmiges Zirkoniumchlorid wurde durch überleiten von HCl-Gas über Späne aus metallischem Zirkonium gewonnen. Das Aufheizen der Proben bis zur Beschichtungstemperatur erfolgt jeweils in einer Inertgasatmosphäre, z.B. aus Argon. Die Abkühlung nach erfolgter Beschichtung wird unter einer Wasserstoffatmosphäre durchgeführt.

### Versuch 1 (Stand der Technik):

Bei einer Temperatur von 1010°C und einem Druck von 30 kPa wurde ein Gasgemisch aus 1,5 % TiCl₄, 1,2 % ZrCl₄, 3 % CH₄, 15 % N₂, Rest H₂ für eine Zeitdauer von 180 Minuten in das Reaktionsgefäß eingeleitet. Nach der Abkühlung wurden die Proben entnommen und analysiert. Die auf den in dem Reaktionsgefäß angeordneten Hartmetallsubstraten abgeschiedenen Schichten waren abhängig von der Position im Reaktionsgefäß zwischen 7 und 10 *µ*m dick. Durch eine Röntgenbeugungsuntersuchung und Analysen mit einer Elektronenstrahlmikrosonde konnte festgestellt werden, daß die abgeschiedenen Schichten aus Ti(C,N) bestanden. Der Zirkoniumgehalt in dieser Schicht war kleiner als 1 %. Dagegen fanden sich in den kalten Abgasrohren feste Ablagerungen von Zirkoniumchlorid. Die Herstellung von quaternären Carbonitriden ist auf diese Weise nicht möglich. Die Härte der abgeschiedenen Titancarbonitridschicht wurde mit einem Mikrohärtetestgerät bestimmt und ergab 2350 HV05 (Vickers-Härte bei 50 g Belastung).

### Versuch 2:

Im Unterschied zu Versuch 1 wurde anstelle von CH₄ und N₂ gasförmiges Acetonitril CH₃-CN in einer Menge von 3,5 % einspeist. Der Druck betrug 8 kPa. Nach dreistündiger Beschichtung hatten sich auf den Substraten zwischen 9 und 12 *µ*m dicke, metallisch graue Schichten gebildet. Durch Röntgenbildung wurde festgestellt, daß der abgeschiedene Schichtstoff aus einer einheitlichen kubisch flächenzentrierten Phase mit einer Gitterkonstanten von 0,4365 nm besteht. Durch Elektronenstrahlmikroanalysen wurde gefunden, daß die Schichten eine formelmäßige Zusammensetzung von (Ti_{0.64}Zr_{0.36})(C_{0.62}N_{0.38}) haben. Außerdem wurden noch unvermeidliche Kontaminationen an Sauerstoff (unter 0,3 %) und an Cobalt (0,6 % nahe der Grenzfläche zwischen dem Hartmetallsubstrat und der aufgetragenen Schicht) festgestellt. Im Unterschied zu dem vorbeschriebenen Erstversuch fanden sich keine Ablagerungen von Zirkonchlorid im Abgasrohr, so daß von einer nahezu vollständigen Reaktion des zugeführten ZrCl₄ ausgegangen werden kann. Die an verschiedenen Wendeschneidplatten gemessenen Mikrohärten lagen zwischen 2800 und 3400 HV05, also erheblich über den Mikrohärten, die die nach dem Stand der Technik herstellbaren Ti(C,N)-Schichten haben. Die durch CVD hergestellte quaternäre Schicht besaß eine hohe Oberflächengüte, d.h., eine relativ glatte Oberfläche mit geringer Rauhtiefe.

### Versuch 3:

Anstelle des in Versuch 2 verwendeten Zirkonchlorids ZrCl₄ wurde Hafniumchlorid HfCl₄ in derselben Menge eingespeist. Auf den Hartmetallsubstraten bildeten sich 9 bis 13 *µ*m dicke Hartstoffschichten, die ebenfalls aus einer einheitlichen, kubisch flächenzentrierten Phase mit einer Gitterkonstanten von 0,4401 nm bestanden. Die Analyse ergab eine formelmäßige Zusammensetzung von (Ti_{0.67}Hf_{0.33})(C_{0.58}N_{0.42}). Es wurden Mikrohärten zwischen 2920 bis 3550 HV05 gemessen.

### Versuch 4:

Entsprechend den in Versuch 2 beschriebenen Bedingungen wurde anstelle von Acetonitril ein Gas mit einer einfachen C-N-Bindung verwendet, nämlich Methyamin. Die hergestellten quaternären Hartstoffschichten besaßen eine kubisch flächenzentrierte Struktur. Die der Formel (Ti_{0.86}Zr_{0.14})(C_{0.72}N_{0.18}) entsprechende Zusammensetzung wies jedoch im Vergleich der Beschichtung, die nach Versuch 2 erhalten wurde, einen geringeren Zirkoniumgehalt auf, obwohl gleiche Ausgangsmengen ZrCl₄ verwendet worden sind.

### Versuch 5:

Auf Wendeschneidplatten wurde zunächst eine ca. 1 *µ*m dicke Schicht aus Titannitrid aus einem Gasgemisch von 1,5 % TiCl₄, 25 % N₂, Rest H₂ abgeschieden. Hierauf wurde eine 8 *µ*m dicke Schicht aus einem Hartstoff (Ti,Zr)(C,N) entsprechend der Versuchsbeschreibung zu Versuch 2 abgeschieden. Die abschließende letzte Schicht wurde aus einer Gasmischung aus 2 % AlCl₃, 5 % CO₂ und 93 % H₂-Gasphase abgeschieden, jeweils in Dicken zwischen 1 bis 5 *µ*m. Die Schichtfolge lautete somit TiN-(Ti,Zr)(C,N)-Al₂O₃; der Substratkörper war ein Hartmetall. (WC-Co). Die so hergestellten Wendeschneidplatten wurden für vergleichende Schneidhaltigkeitsuntersuchungen verwendet.

Auf einer Drehmaschine wurden die in den verschiedenen Versuchen erhaltenen beschichteten Wendeschneidplatten erprobt. Dabei wurde ein sich abrasiv verhaltender Gußstahl mit einer Härte von 320 HB bearbeitet. Die Wendeschneidplatten hatten die Bezeichnung CNMG 120412. Bei Versuchen wurde mit folgenden Einstellungen der Drehmaschine gearbeitet:
Schnittgeschwindigkeit 100 m/min,
Schnittiefe 1,5 mm,
Vorschub 0,28 mm/Umdrehung.

Für diese vergleichenden Tests wurden Wendeschneidplatten mit annähernd gleicher Schichtdicke von 10 *µ*m ausgewählt. Es wurde die Standzeit bis zum Erreichen einer Verschleißmarkenbreite von 0,3 mm bestimmt. Die Resultate sind im folgenden aufgeführt:

| Versuch | Beschichtung | Standzeit (min) |
|---|---|---|
| 1 | Ti(C,N) | 18 |
| 2 | (Ti_{0.64}Zr_{0.36})(C_{0.62}N_{0.38}) | 34 |
| 3 | (Ti_{0.67}Hf_{0.33})(C_{0.58}N_{0.42}) | 32 |
| 4 | (Ti_{0.76}Zr_{0.24})(C_{0.72}N_{0.18}) | 28 |

Die vorstehende Tabelle zeigt, daß die erfindungsgemäßen Beschichtungen entsprechend Versuchen 2 bis 4 erheblich verbesserte Standzeiten aufweisen.

In einem weiteren Versuch ist eine Reihe von Wendeschneidplatten hergestellt worden, die einen Hartmetallsubstratkörper und eine Mehrlagenbeschichtung aufwiesen. Die mehrlagigen Schichten hatten die in Versuch 5 beschriebene Schichtfolge, die Probenkörper waren Wendeschneidplatten der Geometrie CNMG 120412. Die betreffenden Versuche unter denselben Versuchsbedingungen, wie vorbeschrieben, erbrachten folgende Resultate

| Beschichtung | Standzeit (min) |
|---|---|
| TiN+Ti(C,N)+Al₂O₃ (Stand der Technik) | 42 |
| | |
| TiN+(Ti_{0.64}Zr_{0.36})(C_{0.62}N_{0.38})+Al₂O₃ (erfindungsgemäß) | 51 |

Auch bei mehrlagigen beschichteten Wendeschneidplatten, von denen eine Schicht eine Multikomponentenschicht - hier (Ti,Zr)(C,N) war, erhält man somit weitaus bessere Verschleißeigenschaften bei spanabhebenden Werkzeugen.

Für die Versuche 6 bis 11 wurde das in der DE 38 41 731 C1 beschriebene Plasma-CVD-Verfahren verwendet, die dort beschriebene Verfahrenstechnik wird auch im Falle der vorliegenden Erfindung benutzt. Bei einer Beschichtungstemperatur zwischen 400°C und 750°C wird das Substrat als Kathode geschaltet und hieran eine gepulste Gleichspannung angelegt. In den Pausen zwischen den stromstarken Pulsen mit Spannungen zwischen 200 und 900 V und einer Puls-Dauer zwischen 20 *µ*s und 20 ms wird eine Restspannung aufrechterhalten, die etwas größer als die Ionisierungspotentiale der Prozeßgase sein soll (vorzugsweise ca. 15 bis 20 eV). Im Reaktionsraum entsteht ein Glimmentladungsplasma, welches aus geladene Atomen, Molekülen und Molekülfragmenten besteht. Im durchgeführten Versuch sind etwa 400 Wendeschneidplatten im Reaktionsgefäß (Abmessungen 12,4 x 12,4 x 4 mm) gleichzeitig angeordnet und beschichtet worden. Die Temperatur wird durch eine externe Heizung zwischen 200°C und 750°C eingestellt. Bei der Beschichtung beträgt der Innendruck zwischen 50 und 5000 Pa. Die Gasmischeinrichtung ermöglicht das Einleiten von Mischungen aus unterschiedlichen Gasen in genauer Dosierung. Als Hauptbestandteil der zugeführten Gase wird Wasserstoff und Argon eingeleitet. Gasförmiges Titantetrachlorid wird durch Verdampfung von flüssigem Titantetrachlorid gewonnen. Gasförmiges Zirkoniumchlorid wird durch überleiten von HCl-Gas über Späne aus metallischem Zirkonium erhalten. Das Aufheizen der Proben bis zu Beschichtungstemperatur erfolgt jeweils in einem Inertgas, wie beispielsweise Argon.

### Versuch 6 (Stand der Technik):

Bei einer Temperatur von 550°C und einem Druck von 80 Pa wird ein Gasgemisch aus 1,8 % TiCl₄, 1,8 % ZrCl₄, 5 % CH₄, 20 % N₂, 40 % H₂ und 31,4 % Ar für eine Zeitdauer von 120 Minuten in das Reaktionsgefäß geleitet. Nach der Abkühlung werden die Proben entnommen und analysiert. Die Dicken der auf den Hartmetallsubstraten abgeschiedenen Schichten betragen 3,8 bis 4,6 *µ*m. Durch eine Röntgenbeugungsuntersuchung und Analysen mit einer Elektronenstrahlmikrosonde wird festgestellt, daß es sich um Schichten aus Ti(C,N) handelt. Der Zirkoniumgehalt der Schicht ist kleiner als 1 %. Dagegen finden sich in den kalten Abgasrohren feste Ablagerungen von ZrCl₄. Mit einem Mikrohärtetestgerät wird der Härtewert der hergestellten Schichten mit ca. 2400 HV05 bestimmt (Vickers-Härte bei 50 g Belastung).

### Versuch 7:

Im Unterschied zu Versuch 6 wird anstelle von CH₄ und N₂ gasförmiges Acetonitril CH₃-CN in einer Menge von 3,5 % in den Reaktionsraum geleitet. Die prozentualen Mengen an Metallchloriden wurden entsprechend Versuch 6 beibehalten, der Anteil der Trägergase H₂ und Ar wurde im gleichen Maße um jeweils 21,25 % gegenüber den in Versuch 6 angegebenen prozentualen Werten erhöht. Der Druck beträgt 300 Pa. Nach zweistündiger Beschichtung bildeten sich auf den Substraten 4 bis 4,4 *µ*m dicke, metallisch graue Schichten mit einer einheitlichen kubisch flächenzentrierten Phase mit einer Gitterkonstanten von 0,4450 nm, was durch Röntgenbeugungsuntersuchungen feststellbar ist. Eine Elektronenstrahlmikroanalyse ergibt, daß die Schichten eine formelmäßige Zusammensetzung von (Ti_{0.62}Zr_{0.38}) (C_{0.60}N_{0.40}) haben. Im Unterschied zu Versuch 6 finden sich keine Ablagerungen von Zirkontetrachlorid im Abgasrohr, was auf eine praktisch vollständige Reaktion des zugeführten Zirkontetrachlorid schließen läßt. Die an verschiedenen beschichteten Wendeschneidplatten gemessenen Mikrohärten liegen zwischen 3200 und 3500 HV05.

### Versuch 8:

Anstelle des in Versuch 7 verwendeten Zirkontetrachlorids ZrCl₄ wird Hafniumchlorid HfCl₄ in der gleichen Menge eingespeist. Bei gleichen Bedinungen werden 3,6 bis 4,2 *µ*m dicke Hartstoffschichten erhalten, die ebenfalls aus einem einheitlichen, kubisch flächenzentrierten Phase mit einer Gitterkonstanten von 0,4396 nm bestehen. Eine Analyse ergibt eine formelmäßige Zusammensetzung von (Ti_{0.65}Hf_{0.35})(C_{0.56}N_{0.44}). Die Mikrohärten der hergestellten Beschichtungen liegen zwischen 3250 und 3650 HV05.

### Versuch 9:

Entsprechend den in Versuch 7 beschriebenen Bedingungen wird anstelle von Acetonitril Methylamin zugeführt, das eine Einfachbindung zwischen dem Kohlenstoff und Stickstoff aufweist. Auch hier können quaternäre Hartstoffschichten mit kubisch flächenzentrierter Struktur erhalten werden, die der Formel (Ti_{0.84}Zr_{0.16})(C_{0.70}N_{0.29}) entsprechende Zusammensetzung aufweisen. Allerdings zeigt der Vergleich zum Ergebnis nach Versuch 7 einen geringeren Zirkoniumgehalt, obwohl von gleichen Mengen an TiCl₄ und ZrCl₄ ausgegangen wird.

### Versuch 10:

Auf Wendeschneidplatten wird zunächst eine ca. 0,5 *µ*m dicke Schicht aus TiN aus einem Gasgemisch bestehend aus 2 % TiCl₄, 20 % N₂, 40 % H₂, Rest Ar abgeschieden. Hierauf wird eine 5 *µ*m dicke Schicht aus dem Hartstoff (Ti,Zr)(C,N) entsprechend Versuch 7 abgeschieden. Als weitere Schicht wird eine 0,5 *µ*m dicke Schicht aus TiN aufgebracht, so daß sich eine Mehrlagenbeschichtung aus drei einzelnen Schichten mit einer Gesamtdicke von ca. 6 *µ*m ergibt. Die derart beschichteten Wendeschneidplatten werden für vergleichende Schneidhaltigkeitsuntersuchungen verwendet.

Auf einer Fräsmaschine werden die in den verschiedenen Versuchen erhaltenen verschiedenen Wendeschneidplatten vom Typ SEKN 1203 AFTN erprobt. Als Bearbeitungswerkstoff werden 60 mm breite und 600 mm lange Blöcke aus einem Vergütungsstahl 42CrMo4V (1100 N/mm²) durch Stirnfräsen bearbeitet. Die Versuche werden mit folgenden Einstellungen der Fräsmaschine durchgeführt:
Schnittgeschwindigkeit 220 m/min, Schnittiefe 5 mm, Vorschub 0,25 mm/Zahn.

Für die vergleichenden Tests werden jeweils Wendeschneidplatten mit annähernd gleicher Schichtdicke (ca. 5 bis 6 *µ*m) ausgewählt. In dem Schneidhaltigkeitsversuch wird so lange Bahn für Bahn gefräst, bis die Verschleißmarkenbreite an der Hauptschneide mehr als 0,5 mm beträgt. Die im folgenden wiedergegebenen erzielten Fräslängen sind ein Kriterium für die Leistungsfähigkeit der jeweiligen Wendeschneidplatten:

| Versuch | Beschichtung | Fräslänge (m) |
|---|---|---|
| | | |
| 1 | Ti(C,N) | 10,8 |
| 2 | (Ti_{0.62}Zr_{0.38})(C_{0.60}N_{0.40}) | 14,4 |
| 3 | (Ti_{0.65}Hf_{0.35})(C_{0.56}N_{0.44}) | 15,6 |
| 4 | (Ti_{0.84}Zr_{0.16})(C_{0.70}N_{0.29}) | 12,0 |

Die obengenannte Tabelle zeigt, daß die erfindungsgemäßen Beschichtungen nach Versuchen 7 bis 9 ein erheblich verbessertes Standvermögen zeigen.

### Versuch 11:

Es ist bekannt, daß die Gebrauchsdauer von Wendeschneidplatten (wegen der vielfältigen Einflußfaktoren auf dem Verschleißvorgang an der Schneide) durch Auftragen von Mehrfachbeschichtungen gesteigert werden kann. Im Unterschied zu Versuch 10 werden Wendeschneidplatten mit einer Mehrfachbeschichtung hergestellt, bei der eine Schicht eine Multikomponenten-Carbonitrid-Schicht ist. Im vorliegenden Versuch werden daher bei gleicher Wendeschneidplattengeometrie und Gesamt-Schichtdicke die aus der nachfolgenden Tabelle entnehmbaren Beschichtungen mit einer Schichtfolge TiN-Ti(C,N) und TiN ausgewählt. Die Resultate sind der folgenden Tabelle zu entnehmen:

| Beschichtung | Fräslänge (m) |
|---|---|
| | |
| TiN+Ti(C,N)+TiN (Stand der Technik) | 13,8 |
| | |
| TiN+(Ti_{0.62}Zr_{0.38})(C_{0.60}N_{0.40})+TiN (erfindungsgemäß) | 18,6 |

Auch bei mehrlagigen beschichteten Wendeschneidplatten konnten die Wendeschneidplatten, deren mittlere Schicht aus einer Titan-Zirkonium-Carbonitrid-Schicht bestand, eine bessere Verschleißbeständigkeit erzielen.

## Patentansprüche

1. Verfahren zur Herstellung von Multikomponenten-, insbesondere quaternären, Carbonitrid-Hartstoffschichten mit mindestens zwei Metallen aus der Gruppe Ti, Zr, Hf, V, Nb, Ta, Cr, Mo und W, **dadurch gekennzeichnet, daß** die Hartstoffschichten mittels CVD aufgetragen werden, wobei die Gasphase bei einer Reaktionstemperatur zwischen 700°C und 1100°C und vorzugsweise bei Drücken zwischen 5 kPa und 100 kPa, neben H₂ und/oder Ar sowie Chloriden der obengenannten Metalle auch Kohlenstoff- und Stickstoff-Donatoren enthält, die eine C-N-Molekülgruppe aufweisen.

2. Verfahren nach Anspruch 1, **dadurch gekennzeichnet, daß** die C-N-Molekülgruppe eine Cyanidgruppe-CN mit einer Dreifachbindung zwischen dem Kohlenstoff und dem Stickstoff enthält, deren Abstand bei Raumtemperatur zwischen 0,114 und 0,118 nm beträgt, vorzugsweise unter Verwendung von Acetonitril und/oder daß die CN-Molekülgruppe Molekülgruppen mit einer einfachen Bindung zwischen dem Kohlenstoff und dem Stickstoff enthält.

3. Verfahren nach einem der Ansprüche 1 oder 2, **dadurch gekennzeichnet, daß** die Hartstoffschicht aus (Ti,Zr)(C,N) oder (Ti,Hf)(C,N) besteht.

4. Verfahren zur Herstellung von Multikomponenten-, insbesondere quaternären, Carbonitrid-Hartstoffschichten mit mindestens zwei Metallen aus der Gruppe Ti, Zr, Hf, V, Nb, Ta, Cr, Mo und W, vorzugsweise aus der IVa- oder Va-Gruppe des Periodensystemes durch plasmaaktiviertes CVD auf einem Grundkörper aus einem Hartmetall, Cermet, Stahl oder einer Keramik, **dadurch gekennzeichnet, daß** die reaktive Gasatmosphäre bei der eingestellten Reaktionstemperatur neben Wasserstoff, Argon, zwei oder mehr unterschiedlichen Chloriden der genannten Metalle auch ionisierte und/oder nicht ionisierte Kohlenstoff-Stickstoff-Donatoren mit Dreifachbindungen enthält, wobei der Abstand der Bindung zwischen dem Kohlenstoff und dem Stickstoff bei Raumtemperatur zwischen 0,114 und 0,118 nm liegt.

5. Verfahren nach Anspruch 4, **dadurch gekennzeichnet, daß** die ionisierten und die nicht ionisierten C-N-Donatoren durch Ionisierung und thermische Dissoziation von Gasen mit Cyanidgruppen mittels einer Plasmaaktivierung bei Temperaturen zwischen 400°C und 700°C erzeugt werden.

6. Verfahren nach Anspruch 4 oder 5, **dadurch gekennzeichnet, daß** das Reaktionsgemisch Acetonitril als Kohlenstoff-Stickstoff-Donator enthält oder daß die Kohlenstoff-Stickstoff-Donatoren im Reaktionsgasgemisch auch CN-Gruppen mit einer Einfachbindung zwischen dem Kohlenstoff und dem Stickstoff enthalten.

7. Verfahren nach einem der Ansprüche 4 bis 6, **dadurch gekennzeichnet, daß** mindestens eine Hartstoffschicht einer mehrlagigen Beschichtung aus (Ti, Zr)(C,N) und/oder (Ti,Hf)(C,N) besteht.

8. Verfahren nach einem der Ansprüche 4 bis 7, **dadurch gekennzeichnet, daß** die Plasmaaktivierung an dem als Kathode geschalteten Substratkörper mit einer gepulsten' Gleichspannung durchgeführt wird.

9. Verbundkörper, bestehend aus einem Hartmetall-, Cermet-, Stahl- oder Keramik-Substratkörper und mindestens einer einphasigen Metallcarbonitrid-Hartstoffschicht, bei der das Metall zwei oder mehrere Elemente der Gruppe Ti, Zr, Hf, V, Nb, Ta, Cr, Mo und W enthält und wobei das Metallcarbonitrid durch ein CVD-Verfahren oder ein Plasmaaktiviertes CVD-Verfahren abgeschieden worden ist,
**dadurch gekennzeichnet,**
**daß** die abgeschiedene Schicht die Zusammensetzung (TiₓZr₁₋ₓ)(C_{y}N_{1-y}) mit 0,4<x<0,95 und 0,2<y<0,9 mit einer kubisch flächenzentrierten Gitterstruktur aufweist, deren Gitterkonstante im Bereich zwischen 0,430 und 0,455 liegt oder daß die abgeschiedene Schicht die Zusammensetzung (TiₓHf₁₋ₓ)(C_{y}N_{1-y}) mit 0,4<x<0,95 und 0,2<y<0,9 mit einer kubisch flächenzentrierten Gitterstruktur aufweist, deren Gitterkonstante im Bereich zwischen 0,430 und 0,450 liegt.

10. Verbundkörper nach Anspruch 9, **dadurch gekennzeichnet,**
**daß** der Substratkörper mit mehreren Schichten aus Carbiden, Nitriden und/oder Carbonitriden des Ti, Zr, Hf, insbesondere TiC, Ti(C,N), TiN, und/oder Al₂O₃ und mindestens einer Multimetallcarbonitridschicht überzogen ist und/oder daß dieser als Werkzeug, insbesondere Schneidwerkzeug zur spanenden Bearbeitung ausgebildet ist.

## Claims

1. Process for the production of a multicomponent, particularly quaternary carbonitride hard-material layer with at least two metals of the Group Ti, Zr, Hf, V, Nb, Ta, Cr, Mo and W,
**characterized in that**
the hard-material layers are applied by CVD, whereby at a reaction temperature between 700°C and 1100°C and preferably at pressures between 5 kPa and 100 kPa, the gas phase contains, besides H₂ and/or argon and chlorides of above mentioned metals, also carbon and nitrogen donors which have a C-N-molecular group.

2. Process according to claim 1, **characterized in that** the C-N-molecular group contains a cyanide group-CN with a triple bond between the carbon and the nitrogen, whose distance at room temperatures ranges between 0,114 and 0,118 nm, preferably by using acetonitrile and/or that the CN-molecular group contains molecular groups with a single bond between the carbon and the nitrogen.

3. Process according to one of claims 1 or 2, **characterized in that** the hard-material layer consists of (Ti,Zr)(C,N) or (Ti, Hf)(C,N).

4. Process for the production through the plasma-activated CVD process of multicomponent, particularly quaternary, carbonitride hard-material layers with at least two metals of the Group Ti, Zr, Hf, V, Nb, Ta, Cr, Mo and W, preferably of the Groups IVa or Va of the periodic system on a substrate body of hard metal, cermet, steel or a ceramic, **characterized in that** the reactive gas atmosphere at the set reaction temperature contains besides hydrogen, argon, and two or more different chlorides of the mentioned metals, also ionized and/or nonionized carbon-nitrogen donors with triple bonds, whereby the bond distance between the carbon and the nitrogen at room temperature ranges between 0,114 and 0,118 nm.

5. Process according to claim 4, **characterized in that** the ionized and the nonionized C-N-donors are produced through dissociation from gases with cyanide groups by means of plasma activation at temperatures between 400°C and 700°C.

6. Process according to claim 4 or 5, **characterized in that** the reaction mixture contains acetonitrile as a carbon-nitrogen-donor or that the carbon-nitrogen- donors in the reaction mixture also contain CN-groups with a single bond between the carbon and the nitrogen.

7. Process according to one of claims 4 to 6, **characterized in that** at least one hard layer of a multilayer coating consists of (Ti,Zr)(C,N) and/or of (Ti,Hf)(C,N).

8. Process according to one of claims 4 to 7, **characterized in that** the plasma activation is performed at the substrate body connected as cathode with a pulsed direct voltage.

9. Composite body consisting of a hard metal, cermet, steel or ceramic substrate body and at least one single phase hard-material-carbonitride layer, the metal of which contains two or more elements of the Group Ti, Zr, Hf, V, Nb, Ta, Cr, Mo and W and the metal-carbonitride being deposited by means of a CVD process or a plasma activated CVD process **characterized in that** the deposited layer has the composition (TiₓZr₁₋ₓ) (C_{y}N_{1-y}) with 0,4 < x < 0,95 and 0,2 < y < 0,9 with a cubic surface-centered lattice structure, whose lattice constant lies within the range of 0,430 and 0,455 or that the deposited layer has the composition (TiₓHf₁₋ₓ) (C_{y}N_{1-y}) with 0,4 < x <0,95 and 0,2 < y < 0,9 with a cubic surface-centered lattice structure, whose lattice constant lies within the range of 0,430 and 0,450.

10. Composite body according to claim 9, **characterized in that** the substrate body is coated with several layers of carbides, nitrides and/or carbonitrides of Ti, Zr, Hf, particularly TiC, Ti(C,N), TiN and/or Al₂O₃, and at least one multimetal carbonitride layer and/or that it is shaped as a tool, particularly a cutting tool for machining processes.

## Revendications

1. Procédé de fabrication de couches de matière dure à plusieurs composants, en particulier de couches quaternaires de matière dure de carbonitrure avec du moins deux métaux du groupe Ti, Zr, Hf, V, Nb, Ta, Cr, Mo et W, **caractérisé par** le fait que les couches de matière dure sont appliquées au moyen du CVD, la phase gazeuse contenant, à une température de réaction comprise entre 700°C et 1100°C et de préférence à des pressions comprises entre 5 kPa et 100 kPa, outre H₂ et/ou Ar ainsi que des chlorures des métaux susmentionnés, aussi des donneurs de carbone et d'azote qui présentent un groupe moléculaire C-N.

2. Procédé selon la revendication 1, **caractérisé par** le fait que le groupe moléculaire C-N comprend un groupe cyanure CN avec une liaison triple entre le carbone et l'azote, dont la distance à la température ambiante est comprise entre 0,114 et 0,118 nm, de préférence avec l'utilisation d'acétonitrile, et/ou que le groupe moléculaire CN contient des groupes moléculaires avec une liaison simple entre le carbone et l'azote.

3. Procédé selon l'une des revendications 1 ou 2, **caractérisé par** le fait que la couche de matière dure se compose de (Ti, Zr) (C,N) ou de (Ti,Hf) (C,N).

4. Procédé de fabrication de couches de matière dure à plusieurs composants, en particulier de couches quaternaires de matière dure de carbonitrure avec du moins deux métaux du groupe Ti, Zr, Hf, V, Nb, Ta, Cr, Mo et W, de préférence du groupe IVa ou Va de la classification périodique des éléments, par le procédé CVD activé par plasma sur un coprs de base en un métal dur, un cermet, un acier ou une céramique, **caractérisé par** le fait que l'atmosphère réactif de gaz à la température réglée de réaction contient outre l'hydrogène, l'argon, deux ou plusieurs chlorures différents des métaux mentionnés, aussi des donneurs ionisés et/ou non ionisés de carbone et d'azote avec des liaisons triples, la distance de la liaison entre le carbone et l'azote à la température ambiante étant comprise entre 0,114 et 0,118 nm.

5. Procédé selon la revendication 4, **caractérisé par** le fait que les donneurs C-N ionisés et les donneurs C-N non ionisés sont produits par ionisation et dissociation thermique de gaz avec des groupes cyanure au moyen d'une activation par plasma à des températures comprises entre 400°C et 700°C.

6. Procédé selon la revendication 4 ou 5, **caractérisé par** le fait que le mélange de réaction contient de l'acétonitrile en tant que donneur de carbone et d'azote, ou que les donneurs de carbone et d'azote dans le mélange de réaction contiennent aussi des groupes CN avec une liaison simple entre le carbone et l'azote.

7. Procédé selon l'une des revendications 4 à 6, **caractérisé par** le fait que du moins une couche de matière dure d'un revêtement à plusieurs couches se compose de (Ti, Zr) (C,N) et/ou de (Ti, Hf) (C,N).

8. Procédé selon l'une des revendications 4 à 7, **caractérisé par** le fait que l'activation par plasma sur le corps substrat connecté en tant que cathode est effectuée avec une tension continue pulsée.

9. Corps composite se composant d'un corps substrat en métal dur, en cermet, en acier ou en céramique et d'au moins une couche de matière dure à phase unique en carbonitrure de métal, dans laquelle le métal comprend deux ou plusieurs éléments du groupe Ti, Zr, Hf, V, Nb, Ta, Cr, Mo et W et le carbonitrure de métal étant déposé par un procédé CVD ou par un procédé CVD activé par plasma, **caractérisé par le fait** que la couche déposée présente la composition (TiₓZr₁₋ₓ)(C_{y}N_{1-y}) avec 0,4<x<0,95 et 0,2<y<0,9 avec une structure de réseau cubique à faces centrées dont la constante de réseau est comprise entre 0,430 et 0,455, ou que la couche déposée présente la composition (TiₓHf₁₋ₓ)(C_{y}N_{1-y}) avec 0,4<x<0,95 et 0,2<y<0,9 avec une structure de réseau cubique à faces centrées dont la constante de réseau est comprise entre 0,430 et 0,450.

10. Corps composite selon la revendication 9, **caractérisé par** le fait que ledit corps substrat est revêtu de plusieurs couches de carbures, nitrures et/ou carbonitrures du Ti, Zr, Hf, en particulier de TiC, Ti(C,N), TiN, et/ou de Al₂O₃ et d'au moins une couche de carbonitrure à plusieurs métaux, et/ou que celui-ci est réalisé comme outil, en particulier comme outil de coupe pour l'usinage à enlèvement de copeaux.
